# EUROPEAN PATENT SPECIFICATION

(11) **EP 0 851 332 B1**
(45) Date of publication and mention of the grant of the patent: **25.02.2004**
(21) Application number: 97310344.3
(22) Date of filing: 19.12.1997
(51) Int. Cl.: G05F 3/24, G05F 3/26, G05F 1/575

(54) **A voltage regulator**
Spannungsregler
Régulateur de tension

(30) Priority: 19.12.1996 US 33679 P
(43) Date of publication of application: 01.07.1998
(73) Proprietor: Texas Instruments Incorporated, Dallas, Texas 75265 (US)
(72) Inventor: Corsi, Marco, Plano, TX 75025 (US); Borden, Robert B., Plano, TX 75023 (US); Kay, Michael R., Greensboro, NC 27407 (US); Salamina, Nicolas, Dallas, TX 75048 (US); Rincon, Gabriel A., Margate, FL 33063 (US)
(74) Representative: Harris, Ian Richard

(56) References cited:
- EP-A- 0 316 781
- EP-A- 0 733 959
- EP-A- 0 745 923

## Description

### FIELD OF THE INVENTION

This invention generally relates to electronic systems and in particular it relates to voltage regulators.

### BACKGROUND OF THE INVENTION

The function of a voltage regulator is to take a varying input voltage supply and generate a stable output voltage. The efficiency of modern power supply systems, especially battery operated ones, is directly related to the useable operating voltage and current over head required by the system's voltage regulator. The useable operating voltage is called the "drop-out" voltage, which is the difference between the input and output voltages of the regulator while the regulator still maintains regulation. The smaller this difference, the more efficient the system. Additionally, batteries can supply only a finite amount of charge, so the more quiescent current the regulator uses (which is wasted current as far as the system is concerned), the less life the battery will have and therefore the system will be less efficient.

EP-A-0316781 discloses a voltage regulator circuit comprising: a first transistor coupled between a voltage supply line and an output node; an amplifier coupled to a control region of the first transistor; and negative feedback circuitry arranged for providing negative feedback to the amplifier.

### SUMMARY OF THE INVENTION

According to the invention there is provided a voltage regulator circuit comprising:
a first transistor coupled between a voltage supply line and an output node, the first transistor being arranged for providing a stable voltage on the output node;
a source follower coupled to a control region of the first transistor;
an amplifier coupled to a control region of the source follower for controlling the response of the first transistor;
negative feedback circuitry coupled between the output node and the amplifier, the negative feedback circuitry being arranged for providing feedback to the amplifier;
a current conveyor coupled to the first transistor; and
positive feedback circuitry coupled between the current conveyer and the source follower.

### BRIEF DESCRIPTION OF THE DRAWINGS

The present invention will now be further described by way of example, with reference to the accompanying drawings in which: the only Figure is a schematic circuit diagram of a preferred embodiment low drop-out (LDO) voltage regulator with PMOS pass element.

### DETAILED DESCRIPTION OF PREFERRED EMBODIMENTS

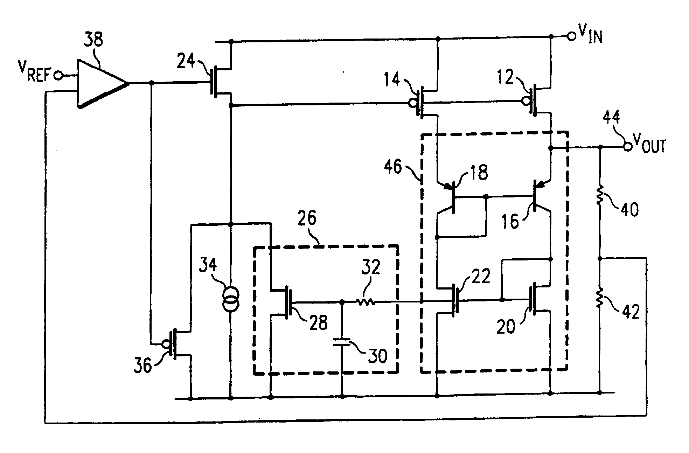

Referring to Fig. 1, a circuit diagram of a low drop-out (LDO) voltage regulator with PMOS pass element is illustrated. This preferred embodiment allows an LDO voltage regulator to be compensated while only consuming small currents and substantially improving the load regulation. The circuit includes PMOS pass device 12 (PMOS transistor); PMOS transistor 14; PNP transistors 16 and 18; NMOS transistors 20 and 22; NMOS transistor 24; positive feedback circuit 26 which includes NMOS transistor 28, capacitor 30, and resistor 32; current source 34; PMOS transistor 36; error amplifier 38 (operational amplifier), resistors 40 and 42, voltage reference V_{REF}, output voltage V_{OUT}, and input voltage V_{IN}.

The operation of the device is explained with reference to the preferred embodiment shown in Figure 1. The output voltage V_{OUT} is regulated by pass transistor 12. The error amp 38, which is an operational amplifier, controls transistor 12 through transistor 24. When the input voltage V_{IN} changes or the current being drawn from an external load at node 44 changes, the output voltage V_{OUT} begins to change causing the voltage across the second resistor 42 to change. The error amp 38 then adjusts the gate voltage of transistor 24 so that the output voltage V_{OUT} is maintained in the desired range.

Current mirror transistor 14 monitors the current of transistor 12. In the preferred embodiment, the ratio of transistor 14 to transistor 12 is such that the current in transistor 14 is only a small fraction of the current in transistor 12 (for example 1:1000). PNP transistors 16 and 18 together with NMOS transistors 20 and 22 form a current conveyor 46 which forces the current in PNP transistors 20 and 22 to be the same. The current conveyor ensures that the V_{DS} and V_{GS} of transistors 12 and 14 are the same. Since the V_{GS} of transistors 12 and 14 are the same, the currents in PNP transistors 16 and 18 are the same. The current in the current conveyor 46 is equal to the current in transistor 14.

The current conveyor current is mirrored to transistor 28. Transistor 28 is larger than transistors 20 and 22 in order to provide sufficient current for the source follower transistor 24 which drives output transistor 12. Transistor 24 is an isolated natural NMOS with a low V_{T}. Resistor 32 and capacitor 30 provide frequency compensation for the positive feedback to make sure the positive feedback never overcomes the negative feedback so that the circuit does not oscillate.

The current conveyor performs two functions. First, it ensures that the external pole and the internal pole remain separated for stability. Second, the positive feedback improves the load regulation by modulating the V_{GS} of transistor 24 proportionately with the V_{GS} of transistor 12. This compensates the output impedance of the circuit.

If there is no output current at output node 44, there will be no current mirrored to transistor 28. Therefore, in order to make sure that there is some current in transistor 24, current source 34 pulls on transistor 24 so that the circuit works where there is no load at output node 44. In the preferred embodiment, current source 34 provides only a small current on the order of one micro amp. With this small current, the power consumption of the circuit will be extremely small when there is no load on the output. This is an important feature for battery powered devices.

Transistor 36 is used to enhance the slew rate of the circuit. Transistor 36 allows the circuit to come back into regulation quickly when there is a rapid change in load. Transistor 36 turns on and helps the transient response when going from no load at output node 44 to a full load or some load condition at node 44.

## Claims

1. A voltage regulator circuit comprising:
a first transistor (12) coupled between a voltage supply line and an output node (44), the first transistor being arranged for providing a stable voltage on the output node;
a source follower (24) coupled to a control region of the first transistor;
an amplifier (38) coupled to a control region of the source follower for controlling the response of the first transistor;
negative feedback circuitry (40,42) coupled between the output node and the amplifier, the negative feedback circuitry being arranged for providing feedback to the amplifier;
a current conveyor (46) coupled to the first transistor; and
positive feedback circuitry (26) coupled between the current conveyer and the source follower.

2. The circuit of claim 1 further comprising:
a current source (34) coupled to the source follower.

3. The circuit of claim 1 or claim 2, wherein the first transistor is a MOS transistor.

4. The circuit of claim 1, claim 2 or claim 3, wherein the current conveyer comprises:
a second transistor (14) having a control region coupled to the control region of the first transistor;
a first bipolar transistor (16) coupled to the first transistor;
a second bipolar transistor (18) coupled to the second transistor, a base region of the second bipolar transistor coupled to a base region of the first bipolar transistor;
a third transistor (20) coupled to the first bipolar transistor; and
a fourth transistor (22) coupled to the second bipolar transistor and to the base region of the first bipolar transistor, a control region of the fourth transistor coupled to a control region of the third transistor and to the first bipolar transistor.

5. The circuit of claim 4, wherein at least one of the second, third and fourth transistors is a MOS transistor.

6. The circuit of any of claims 1 to 5, wherein the positive feedback circuitry comprises:
a positive feedback transistor (28) coupled to the source follower;
a resistor (32) coupled between the current conveyer and a control region of the positive feedback transistor; and
a capacitor (30) coupled to the control region of the positive feedback transistor.

7. The circuit of claims 1 to 6, wherein the negative feedback circuitry comprises:
a first resistor (40) having a first end coupled to the output node and a second end coupled to the amplifier; and
a second resistor (42) coupled to the second end of the first resistor.

8. The circuit of any of claims 1 to 7 further comprising:
a slew rate enhancement transistor (36) coupled to the source follower, wherein a control region of the skew rate enhancement transistor is coupled to the output of the amplifier.

## Revendications

1. Circuit régulateur de tension, comprenant :
un premier transistor (12) couplé entre une ligne d'alimentation de tension et un noeud de sortie (44), le premier transistor étant disposé pour fournir une tension stable sur le noeud de sortie ;
une source suiveuse (24) couplée à une région de contrôle du premier transistor ;
un amplificateur (38) couplé à une région de contrôle de la source suiveuse pour contrôler la réponse du premier transistor ;
une circuiterie de retour négatif (40, 42) couplée entre le noeud de sortie et l'amplificateur, la circuiterie de retour négatif étant disposée pour assurer le retour à l'amplificateur ;
un convoyeur de courant (46) couplé au premier transistor ; et
une circuiterie de retour positif (26) couplée entre le convoyeur de courant et la source suiveuse.

2. Circuit selon la revendication 1, comprenant en outre :
une source de courant (34) couplée à la source suiveuse.

3. Circuit selon la revendication 1 ou la revendication 2, dans lequel le premier transistor est un transistor MOS.

4. Circuit selon la revendication 1, la revendication 2 ou la revendication 3, dans lequel le convoyeur de courant comprend :
un second transistor (14) ayant une région de contrôle couplée à la région de contrôle du premier transistor ;
un premier transistor bipolaire (16) couplé au premier transistor ;
un second transistor bipolaire (18) couplé au second transistor, une région de base du second transistor bipolaire couplée à une région de base du premier transistor bipolaire ;
un troisième transistor (20) couplé au premier transistor bipolaire ; et
un quatrième transistor (22) couplé au second transistor bipolaire et à la région de base du premier transistor bipolaire, une région de contrôle du quatrième transistor couplée à une région de contrôle du troisième transistor et au premier transistor bipolaire.

5. Circuit selon la revendication 4, dans lequel au moins un des second, troisième et quatrième transistors est un transistor MOS.

6. Circuit selon l'une des revendications 1 à 5, dans lequel la circuiterie de retour positif comprend :
un transistor de retour positif (28) couplé à la source suiveuse ;
une résistance (32) couplée entre le convoyeur de courant et une région de contrôle du transistor de retour positif ; et
un condensateur (30) couplé à la région de contrôle du transistor de retour positif.

7. Circuit selon les revendications 1 à 6, dans lequel la circuiterie de retour négatif comprend :
une première résistance (40) ayant une première extrémité couplée au noeud de sortie et une seconde extrémité couplée à l'amplificateur ; et
une seconde résistance (42) couplée à la seconde extrémité de la première résistance.

8. Circuit selon les revendications 1 à 7, comprenant en outre :
un transistor d'amélioration de vitesse de balayage (36) couplé à la source suiveuse, dans lequel une région de contrôle du transistor d'amélioration de vitesse de balayage est couplée à la sortie de l'amplificateur.

## Patentansprüche

1. Spannungsreglerschaltung, welche aufweist:
einen ersten Transistor (12), der zwischen eine Spannungsversorgungsleitung und einen Ausgangsschaltungspunkt (44) geschaltet ist, wobei der erste Transistor dafür eingerichtet ist, am Ausgangsschaltungspunkt eine stabile Spannung bereitzustellen,
einen Source-Folger (24), der mit einer Steuerzone des ersten Transistors gekoppelt ist,
einen Verstärker (38), der mit einer Steuerzone des Source-Folgers gekoppelt ist, um das Ansprechen des ersten Transistors zu steuern,
eine Gegenkopplungs-Schaltungsanordnung (40, 42), die zwischen den Ausgangsschaltungspunkt und den Verstärker geschaltet ist, wobei die Gegenkopplungs-Schaltungsanordnung dafür eingerichtet ist, dem Verstärker eine Rückkopplung bereitzustellen,
eine Strom-Übermittlungseinrichtung (46), die mit dem ersten Transistor gekoppelt ist, und
eine Mitkopplungs-Schaltungsanordnung (26), die zwischen die Strom-Übermittlungseinrichtung und den Source-Folger geschaltet ist.

2. Schaltung nach Anspruch 1, welche weiter aufweist:
eine Stromquelle (34), die mit dem Source-Folger gekoppelt ist.

3. Schaltung nach Anspruch 1 oder 2, wobei der erste Transistor ein MOS-Transistor ist.

4. Schaltung nach Anspruch 1, 2 oder 3, wobei die Strom-Übermittlungseinrichtung aufweist:
einen zweiten Transistor (14) mit einer Steuerzone, die mit der Steuerzone des ersten Transistors gekoppelt ist,
einen ersten Bipolartransistor (16), der mit dem ersten Transistor gekoppelt ist,
einen zweiten Bipolartransistor (18), der mit dem zweiten Transistor gekoppelt ist, wobei eine Basiszone des zweiten Bipolartransistors mit einer Basiszone des ersten Bipolartransistors gekoppelt ist,
einen dritten Transistor (20), der mit dem ersten Bipolartransistor gekoppelt ist, und
einen vierten Transistor (22), der mit dem zweiten Bipolartransistor und mit der Basiszone des ersten Bipolartransistors gekoppelt ist, wobei eine Steuerzone des vierten Transistors mit einer Steuerzone des dritten Transistors und mit dem ersten Bipolartransistor gekoppelt ist.

5. Schaltung nach Anspruch 4, wobei wenigstens einer von dem zweiten, dem dritten und dem vierten Transistor ein MOS-Transistor ist.

6. Schaltung nach einem der Ansprüche 1 bis 5, wobei die Mitkopplungs-Schaltungsanordnung aufweist:
einen Mitkopplungs-Transistor (28), der mit dem Source-Folger gekoppelt ist,
einen Widerstand (32), der zwischen die Strom-Übermittlungseinrichtung und eine Steuerzone des Mitkopplungs-Transistors geschaltet ist, und
einen Kondensator (30), der mit der Steuerzone des Mitkopplungs-Transistors gekoppelt ist.

7. Schaltung nach den Ansprüchen 1 bis 6, wobei die Gegenkopplungs-Schaltungsanordnung aufweist:
einen ersten Widerstand (40), dessen erstes Ende mit dem Ausgangsschaltungspunkt gekoppelt ist und dessen zweites Ende mit dem Verstärker gekoppelt ist, und
einen zweiten Widerstand (42), der mit dem zweiten Ende des ersten Widerstands gekoppelt ist.

8. Schaltung nach einem der Ansprüche 1 bis 7, welche weiter aufweist:
einen Anstiegsraten-Erhöhungstransistor (36), der mit dem Source-Folger gekoppelt ist, wobei eine Steuerzone des Anstiegsraten-Erhöhungstransistors mit dem Ausgang des Verstärkers gekoppelt ist.
